# EUROPEAN PATENT SPECIFICATION

(11) **EP 3 201 963 B1**
(45) Date of publication and mention of the grant of the patent: **01.11.2023**
(21) Application number: 15782003.6
(22) Date of filing: 29.09.2015
(51) Int. Cl.: H10K 85/10, C08G 61/12, H10K 50/15

(54) **ORGANIC LIGHT EMITTING DEVICE**
ORGANISCHE LICHTEMITTIERENDE VORRICHTUNG
DISPOSITIF ÉMETTEUR DE LUMIÈRE ORGANIQUE

(30) Priority: 30.09.2014 GB 201417253
(43) Date of publication of application: 09.08.2017
(73) Proprietor: Cambridge Display Technology Limited, Cambridgeshire, CB3 6DW (GB); Sumitomo Chemical Company, Ltd., Chuo-ku Tokyo 104-8260 (JP)
(72) Inventor: KING, Simon, Godmanchester, Cambridgeshire PE29 2XG (GB); ARCHER, Robert, Godmanchester, Cambridgeshire PE29 2XG (GB); BOURCET, Florence, Godmanchester, Cambridgeshire PE29 2XG (GB); WILSON, Richard, Godmanchester, Cambridgeshire PE29 2XG (GB)
(74) Representative: Gilani, Anwar
(86) International application number: PCT/GB2015/052832
(87) International publication number: WO 2016/051158

(56) References cited:
- EP-A1- 2 511 969
- EP-A2- 2 746 359
- WO-A2-2013/164647
- CN-A- 103 985 822
- US-A1- 2013 285 035
- "TFB", Ossila.com , Retrieved from the Internet: URL:https://www.ossila.com/products/tfb?_p os=1&_sid=55aee056c&_ss=r&variant=20107624 939616 [retrieved on 2020-07-16]

## Description

### Background of the Invention

Electronic devices containing active organic materials are attracting increasing attention for use in devices such as organic light emitting diodes (OLEDs), organic photoresponsive devices (in particular organic photovoltaic devices and organic photosensors), organic transistors and memory array devices. Devices containing active organic materials offer benefits such as low weight, low power consumption and flexibility. Moreover, use of soluble organic materials allows use of solution processing in device manufacture, for example inkjet printing or spin-coating.

An OLED may comprise a substrate carrying an anode, a cathode and one or more organic light-emitting layers between the anode and cathode.

Holes are injected into the device through the anode and electrons are injected through the cathode during operation of the device. Holes in the highest occupied molecular orbital (HOMO) and electrons in the lowest unoccupied molecular orbital (LUMO) of a light-emitting material combine to form an exciton that releases its energy as light.

A light emitting layer may comprise a semiconducting host material and a light-emitting dopant wherein energy is transferred from the host material to the light-emitting dopant. For example, J. Appl. Phys. 65, 3610, 1989 discloses a host material doped with a fluorescent light-emitting dopant (that is, a light-emitting material in which light is emitted via decay of a singlet exciton).

Phosphorescent dopants are also known (that is, a light-emitting dopant in which light is emitted via decay of a triplet exciton).

WO 2005/059921 A1 discloses an organic light-emitting device comprising a hole-transporting layer and an electroluminescent layer comprising a host material and a phosphorescent material. High triplet energy level hole-transporting materials are disclosed in order to prevent quenching of phosphorescence.

WO 2010/119273 discloses an organic electroluminescent device having first and second electroluminescent layers including an electroluminescent layer comprising a hole-transporting material and an electroluminescent electron trapping material.

EP2746359 A2 discloses a composition comprising a triazine polymer and a phosphorescent material for the light-emitting layer of an organic light-emitting device.

WO2013164647 A2 discloses an organic light-emitting device having a first light-emitting layer comprising a fluorescent light-emitting material and a triplet-triplet annihilation promoter, and a second light-emitting layer comprising a phosphorescent material.

US2013285035 A1 discloses an electroluminescent element comprising a light-emitting layer and charge-generating layer.

CN103985822 A discloses an organic mixture comprising a first host and a second host and an organic fluorescence emissive material, wherein the hosts form a type-II heterojunction structure.

EP2511969 A1 discloses an organic electroluminescent element comprising a hole transport layer and luminescent layer which have disposed so as to adjoin each other.

### Summary of the Invention

In a first aspect the invention provides an organic light-emitting device as described in claim 1.

In a second aspect the invention provides a method of forming an organic light-emitting device according to the first aspect, as described in claim 10.

In a third aspect the invention provides an organic light-emitting device as described in claim 12.

In a fourth aspect the invention provides a method of forming an organic light-emitting device according to the third aspect, the method comprising the steps of forming the hole-transporting light-emitting layer over the anode; forming the first light-emitting layer over the hole-transporting light-emitting layer; and forming the cathode over the first light-emitting layer, wherein the hole-transporting light-emitting layer and the first light-emitting layer are each formed by depositing a formulation comprising the material or materials of each said layer and at least one solvent and evaporating the at least one solvent.

### Description of the Drawings

The invention will now be described in more detail with reference to the drawings in which:
Figure 1 illustrates schematically an OLED according to an embodiment of the invention;
Figure 2A illustrates lowest triplet excited state energy levels of materials in a device according to an embodiment of the invention having a structure as illustrated in Figure 1;
Figure 2B illustrates HOMO and LUMO energy levels of materials in a device according to an embodiment of the invention having a structure as illustrated in Figure 1; and
Figure 3 illustrates HOMO and LUMO energy levels of materials in a device according to a further embodiment of the invention having a structure as illustrated in Figure 1; and
Figure 4 is a graph of current density vs. voltage for a hole-only device containing a polymer having a high content of hole-transporting repeat units and hole-blocking repeat units, and for a hole-only device containing a polymer having a relatively low content of hole-transporting repeat units and hole-blocking repeat units.

### Detailed Description of the Invention

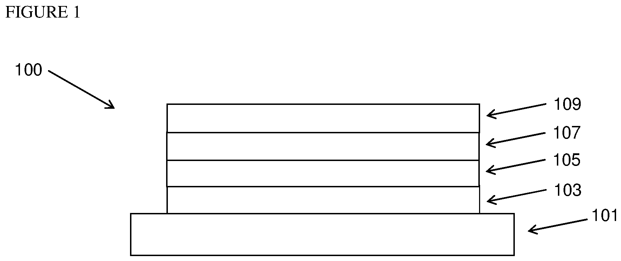

Figure 1, which is not drawn to any scale, illustrates an OLED 100 according to an embodiment of the invention supported on a substrate 101, for example a glass or plastic substrate. The OLED 100 comprises an anode 103, a hole-transporting layer 105, a first light-emitting layer 107 and a cathode 109.

The hole-transporting layer 105 contains a hole-transporting polymer comprising 55 to 95 mol% of hole-transporting repeat units of formula (III) as defined in claim 1.

First light-emitting layer 107 comprises a first light-emitting material selected from fluorescent and phosphorescent materials, and may comprise one or more further light-emitting materials. Preferably, first light-emitting layer 107 comprises the first light-emitting material and at least one further light-emitting material that produces light during operation of the device 100.

Preferably, the or each light-emitting material of the first light-emitting layer 107 is a phosphorescent material. The or each phosphorescent material of the first light-emitting layer 107 may be doped in a host material, suitably an electron-transporting host material. The hole-transporting layer 105 may contain a fluorescent or phosphorescent second light-emitting material that emits light when the device is in operation selected from fluorescent and phosphorescent light-emitting materials, in which case the hole-transporting layer is a second light-emitting layer.

In the case where the hole-transporting layer comprises a second light-emitting material, the second light-emitting material preferably has a longer peak wavelength than the or each light-emitting material of the second light-emitting layer 107.

Preferably, substantially all light emitted by the device is from the light-emitting material or materials of the first light-emitting layer only or, if the hole-transporting layer contains a second light-emitting material, from the first light-emitting layer 107 and the hole-transporting layer 105 Preferably, substantially all light emitted by the device is phosphorescence.

A red light-emitting material may have a photoluminescence spectrum with a peak in the range of about more than 550 up to about 700 nm, optionally in the range of about more than 560 nm or more than 580 nm up to about 630 nm or 650 nm.

A green light-emitting material may have a photoluminescence spectrum with a peak in the range of about more than 490 nm up to about 560 nm, optionally from about 500 nm, 510 nm or 520 nm up to about 560 nm.

A blue light-emitting material may have a photoluminescence spectrum with a peak in the range of up to about 490 nm, optionally about 450-490 nm.

Preferably, the second light-emitting material of hole-transporting layer 105 is a red light-emitting material.

Preferably, the first light-emitting material of first light-emitting layer 107 is selected from green and blue light-emitting materials, and is preferably a blue light-emitting material, more preferably a blue phosphorescent material. The first light-emitting layer 107 may contain both a green and a blue light-emitting material.

The OLED 100 may be a white-emitting OLED wherein light emitted from the hole-transporting light-emitting layer 105 in the case where this layer contains a second emitter and the first light-emitting layer 107 combine to produce white light. White light may be produced from a combination of red, green and blue light-emitting materials.

White-emitting OLEDs as described herein may have a CIE x coordinate equivalent to that emitted by a black body at a temperature in the range of 2500-9000K and a CIE y coordinate within 0.05 or 0.025 of the CIE y co-ordinate of said light emitted by a black body, optionally a CIE x coordinate equivalent to that emitted by a black body at a temperature in the range of 2700-6000K.

The OLED 100 may contain one or more further layers between the anode 103 and the cathode 111, for example one or more charge-transporting, charge-blocking or charge-injecting layers. Preferably, the device comprises a conductive hole-injection layer between the anode and the hole-transporting layer 105.

Preferably, the hole-transporting layer 105 is the semiconducting layer of device 100 that is closest to the anode. Preferably, no further hole-transporting layer is provided between the hole-transporting layer 105 and the anode.

"Conducting material" as used herein means a material having a work function, for example a metal or a degenerate semiconductor.

"Semiconducting material" as used herein means a material having a HOMO and a LUMO level, and a semiconductor layer is a layer comprising a semiconducting material or consisting of one or more semiconducting materials.

Preferably, the hole-transporting layer 105 is adjacent to the first light-emitting layer 107.

The second light-emitting material is a hole-blocking material.

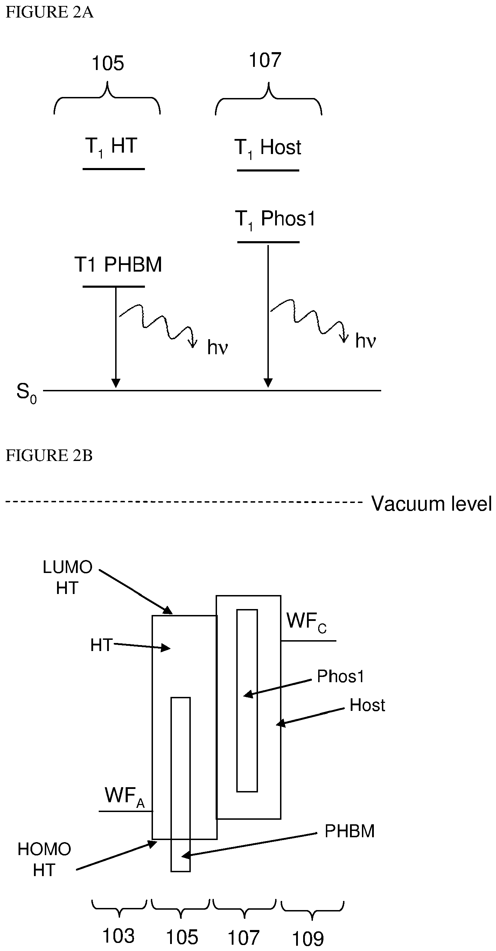

Figure 2A is a schematic illustration of lowest triplet excited state (T₁) energy levels of a device according to an embodiment of the invention having the structure of Figure 1 wherein the hole-transporting layer 105 contains a phosphorescent hole-blocking material PHBM having a relatively long peak wavelength and hole-transporting polymer HT; and the first light-emitting layer 107 contains a host material Host and a phosphorescent light-emitting material Phos1 having a relatively short peak wavelength. The phosphorescent hole-blocking material PHBM may be a red emitting material. The phosphorescent light-emitting material Phos1 may be a green or blue emitting material. In operation, the materials PHBM and Phos1 emit light hv by radiative decay of excitons from T₁ to ground state S₀. In another embodiment (not shown) the phosphorescent hole-blocking material PHBM has a shorter peak wavelength than a phosphorescent light-emitting material in the first light-emitting layer 107.

The first light-emitting layer may contain a further fluorescent or phosphorescent light-emitting material (not shown) such that the device produces white light.

The triplet energy level of the hole-transporting polymer T₁ HT in the hole-transporting layer 105 is preferably the same as or higher than that of the phosphorescent hole-blocking material T₁ PHBM in the hole-transporting light-emitting layer 105 to avoid quenching of phosphorescence from the hole-transporting light-emitting layer 105.

The triplet energy level of the hole-transporting polymer T₁ HT in hole-transporting light-emitting layer 105 is preferably no more than 0.1 eV lower than, and may be the same as or higher than, that of the phosphorescent material T1 Phos1 in the first light-emitting layer 107 to avoid quenching of phosphorescence from Phos1.

In operation, holes are injected from anode 103 into the hole-transporting layer 105 and first light-emitting layer 107.

Electrons are injected from cathode 109 into the first light-emitting layer 107 and into the hole-transporting layer 105.

Holes and electrons recombine in the first light-emitting layer 107, and in the hole-transporting layer 105 if a second light-emitting material is present, to produce excitons that undergo radiative decay to produce fluorescence or phosphorescence. Excitons, in particular triplet excitons, formed in one of the hole-transporting layer and first light-emitting layer 105 and 107 may migrate into the other of the hole-transporting layer and first light-emitting layers 105 and 107 and may be absorbed by a light-emitting material in that layer.

Triplet energy levels as described anywhere herein may be measured from the energy onset of the phosphorescence spectrum measured by low temperature phosphorescence spectroscopy (Y.V. Romaovskii et al, Physical Review Letters, 2000, 85 (5), p1027, A. van Dijken et al, Journal of the American Chemical Society, 2004, 126, p7718).

Triplet energy levels of phosphorescent materials may be measured from their room temperature phosphorescence spectra.

Figure 2B is a schematic illustration of HOMO and LUMO energy levels of the device containing materials as described with reference to Figure 2A. The HOMO-LUMO bandgaps of the materials are shown for each material. For simplicity, only the HOMO and LUMO levels of the hole-transporting polymer HT have been marked.

The anode 103 has a work function WF_{A}. The cathode 109 has a work function WF_{c}.

The phosphorescent hole-blocking material PHBM of hole-transporting light-emitting layer 105 has a HOMO level than is deeper (further from vacuum) than the HOMO of the hole-transporting polymer HT of hole-transporting light-emitting layer 105. Preferably, PHBM has a HOMO level that is at least 0.05 eV, optionally at least 0.1 or at least 0.2 eV further from vacuum than that of HT. This deep HOMO level may limit hole current reaching the first light-emitting layer 107. This hole-blocking effect may be mitigated by providing a high concentration of hole-transporting repeat units in hole-transporting polymer HT.

As shown in Figure 2B, PHBM may also have a LUMO level than is deeper (further from vacuum) than the LUMO of the hole-transporting polymer HT. This deep LUMO level may trap electrons in hole-transporting layer 105, reducing leakage current arising from electrons reaching anode 103 as compared to a device in which the electron trapping PHBM light-emitting material is absent.

The hole-blocking light-emitting material of hole-transporting layer 105 may have a LUMO level that is at least 0.1 eV deeper than, preferably at least 0.2 eV, 0.3 eV, 0.4 eV or 0.5 eV deeper than, the LUMO level of the hole-transporting polymer.

Preferably, the hole-blocking light-emitting material of the hole-transporting layer 105 has a LUMO level that is deeper than, preferably at least 0.1 eV deeper than, the LUMO level of any material in first light-emitting layer 107.

The HOMO of Phos1 is shallower (closer to vacuum) than the HOMO of the hole-transporting polymer HT, although in other embodiments the HOMO of Phos 1 may be substantially the same as or deeper than the HOMO of the hole-transporting polymer HT.

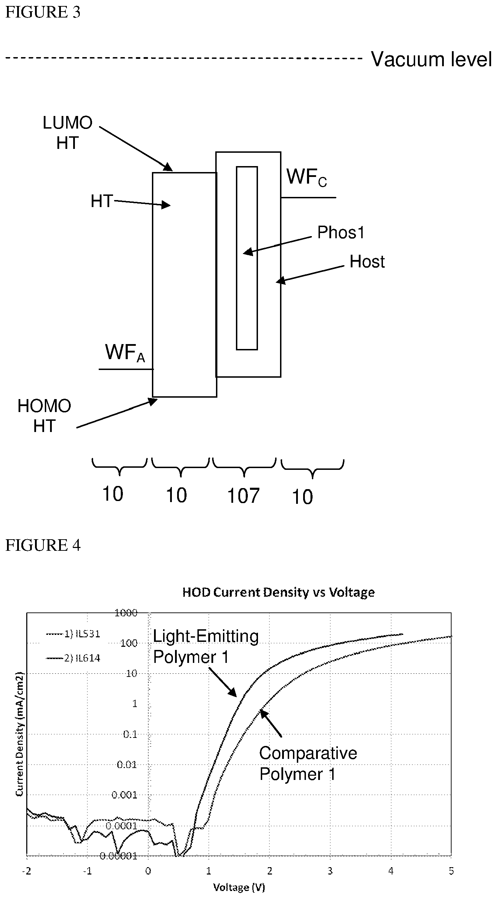

Figure 3 is a schematic illustration of HOMO and LUMO energy levels of a device having the structure of Figure 1 according to a second embodiment of the invention. The HOMO-LUMO bandgaps of the materials are shown for each material. For simplicity, only the HOMO and LUMO levels of the hole-transporting polymer HT have been marked.

The anode 103 has a work function WF_{A}. The cathode 109 has a work function WF_{c}.

The first light-emitting material is a phosphorescent light-emitting material Phos1 that has HOMO level than is shallower (closer to vacuum) than the HOMO of the hole-transporting polymer HT of the hole-transporting layer 105. Preferably, the HOMO of the hole-transporting polymer HT of this embodiment is at least 0.1 eV deeper than the HOMO of the first light-emitting material, and is optionally at least 0.2 eV or 0.3 eV deeper than the HOMO of the first light-emitting material. Optionally, the gap between the HOMO of the first light-emitting material and the hole-transporting material is no more than about 1 eV, preferably no more than about 0.5 eV.

The triplet energy levels of the materials illustrated in Figure 3 may be as described with reference to Figure 2A.

The device of Figure 3 does not contain a second light-emitting material in hole-transporting layer 105. In another embodiment (not shown) the hole-transporting layer 105 comprises a second light-emitting material. This second light-emitting material is a hole blocking material as described with reference to Figure 2B, or may have a HOMO that is substantially the same as or shallower than the HOMO of the hole-transporting polymer HT.

### Hole-transporting materials

Hole transporting polymers as described herein may have a LUMO of 2.5 eV or shallower (i.e. closer to vacuum level), optionally 2.2 eV or shallower and a HOMO of 5.5 eV or shallower, preferably 5.3, 5.2, 5.1 or shallower. HOMO and LUMO values as described herein are as measured by square wave voltammetry.

Hole-transporting polymers include conjugated and non-conjugated polymers. A conjugated hole-transporting copolymer according to claims 1 and 12 comprises repeat units of formula (III): 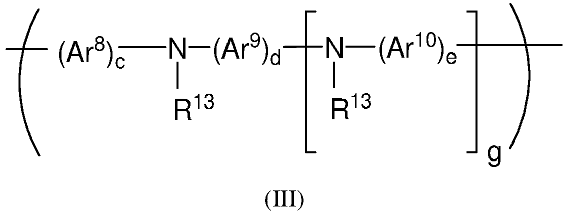
wherein Ar⁸, Ar⁹ and Ar¹⁰ in each occurrence are independently selected from substituted or unsubstituted phenylene; g is 0 or 1;
R¹³ independently in each occurrence is H or a substituent, preferably a substituent, and c, d and e are each independently 1 for the copolymer of claim 1 , and c, d and e are each independently 1, 2 or 3 for the copolymer of claim 12.
R¹³, which may be the same or different in each occurrence when g is 1 or 2, is preferably selected from the group consisting of alkyl, for example C₁₋₂₀ alkyl, Ar¹¹, a branched or linear chain of Ar¹¹ groups, or a crosslinkable unit that is bound directly to the N atom of formula (III) or spaced apart therefrom by a spacer group, wherein Ar¹¹ in each occurrence is independently optionally substituted aryl or heteroaryl. Exemplary spacer groups are C₁₋₂₀ alkyl, phenyl and phenyl-C₁₋₂₀ alkyl.

Any two aromatic or heteroaromatic groups selected from Ar⁸, Ar⁹, and, if present, Ar¹⁰ and Ar¹¹ directly bound to the same N atom may be linked by a direct bond or a divalent linking atom or group to another of Ar⁸, Ar⁹, Ar¹⁰ and Ar¹¹. Preferred divalent linking atoms and groups include O, S; substituted N; and substituted C.

Ar⁸ is phenylene that may be unsubstituted or substituted with one or more substituents.

In the case where g = 0, Ar⁹ is phenylene that may be unsubstituted or substituted with one or more substituents.

In the case where g = 1, Ar⁹ is phenylene that may be unsubstituted or substituted with one or more substituents.

R¹³ is preferably Ar¹¹ or a branched or linear chain of Ar¹¹ groups. Ar¹¹ in each occurrence is preferably phenyl that may be unsubstituted or substituted with one or more substituents.

Exemplary groups R¹³ include the following, each of which may be unsubstituted or substituted with one or more substituents, and wherein * represents a point of attachment to N: 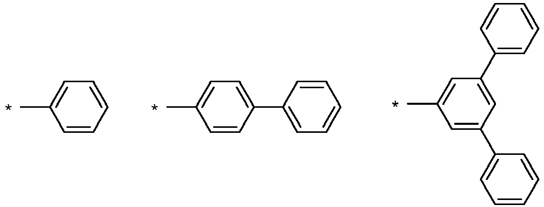
c, d and e are preferably each 1.
Ar⁸, Ar⁹, and, if present, Ar¹⁰ and Ar¹¹ are each independently unsubstituted or substituted with one or more, optionally 1, 2, 3 or 4, substituents. Exemplary substituents may be selected from:
   - substituted or unsubstituted alkyl, optionally C₁₋₂₀ alkyl, wherein one or more non-adjacent C atoms may be replaced with optionally substituted aryl or heteroaryl (preferably phenyl), O, S, C=O or -COO- and one or more H atoms may be replaced with F; and
   - a crosslinkable group attached directly to or forming part of Ar⁸, Ar⁹, Ar¹⁰ or Ar¹¹ or spaced apart therefrom by a spacer group, for example a group comprising a double bond such and a vinyl or acrylate group, or a benzocyclobutane group.

Preferred substituents of Ar⁸, Ar⁹, and, if present, Ar¹⁰ and Ar¹¹ are C₁₋₄₀ hydrocarbyl, preferably C₁₋₂₀ alkyl or a hydrocarbyl crosslinking group.

Preferred repeat units of formula (III) include units of formulae 1-3:

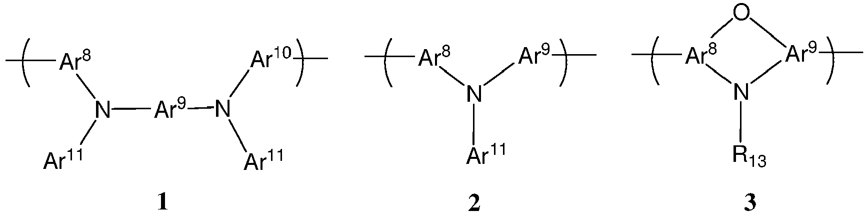

Preferably, Ar⁸, Ar¹⁰ and Ar¹¹ of repeat units of formula 1 are phenyl and Ar⁹ is phenyl.

Preferably, Ar⁸, Ar⁹ and Ar¹¹ of repeat units of formulae 2 and 3 are phenyl.

Preferably, Ar⁸ and Ar⁹ of repeat units of formula 3 are phenyl and R¹¹ is phenyl or a branched or linear chain of phenyl groups.

A hole-transporting polymer comprising repeat units of formula (III) is a copolymer containing repeat units of formula (III) and one or more co-repeat units.

The repeat units of formula (III) may be provided in a molar amount in the range of 55 to 95 mol %.

Exemplary co-repeat units include arylene repeat units that may be unsubstituted or substituted with one or more substituents, for example one or more C₁₋₄₀ hydrocarbyl groups.

Exemplary arylene co-repeat units include 1,2-, 1,3- and 1,4-phenylene repeat units, 3,6-and 2,7- linked fluorene repeat units, indenofluorene, 1,4-linked naphthalene; 2,6-linked naphthalene, 9,10-linked anthracene; 2,6-linked anthracene; phenanthrene, for example 2,7-linked phenanthrene repeat units, each of which may be unsubstituted or substituted with one or more substituents, for example one or more C₁₋₄₀ hydrocarbyl substituents. Linking positions and / or substituents of arylene co-repeat units may be used to alter the T₁ level of a hole-transporting polymer by controlling the extent of conjugation of the hole-transporting polymer.

Substituents may be provided adjacent to one or both linking positions of an arylene co-repeat unit to create steric hindrance with adjacent repeat units, resulting in twisting of the arylene co-repeat unit out of the plane of the adjacent repeat unit.

A twisting repeat unit may have formula (I): 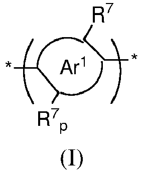 wherein Ar¹ is an arylene group; R⁷ in each occurrence is a substituent; and p is 0 or 1. The one or two substituents R⁷ may be the only substituents of repeat units of formula (I), or one or more further substituents may be present, optionally one or more C₁₋₄₀ hydrocarbyl groups.

The one or two substituents R⁷ adjacent to the linking positions of formula (I) create steric hindrance with one or both repeat units adjacent to the repeat unit of formula (I).

Each Rmay independently be selected from the group consisting of:
- alkyl, optionally C₁₋₂₀ alkyl, wherein one or more non-adjacent C atoms may be replaced with optionally substituted aryl or heteroaryl, O, S, substituted N, C=O or -COO-, and one or more H atoms may be replaced with F;
- aryl and heteroaryl groups that may be unsubstituted or substituted with one or more substituents, preferably phenyl substituted with one or more C₁₋₂₀ alkyl groups;
- a linear or branched chain of aryl or heteroaryl groups, each of which groups may independently be substituted, for example a group of formula -(Ar⁷)ᵣ wherein each Ar⁷ is independently an aryl or heteroaryl group and r is at least 2, preferably a branched or linear chain of phenyl groups each of which may be unsubstituted or substituted with one or more C₁₋₂₀ alkyl groups; and
- a crosslinkable-group, for example a group comprising a double bond such and a vinyl or acrylate group, or a benzocyclobutane group.

In the case where R⁷ comprises an aryl or heteroaryl group, or a linear or branched chain of aryl or heteroaryl groups, the or each aryl or heteroaryl group may be substituted with one or more substituents R⁸ selected from the group consisting of:
alkyl, for example C₁₋₂₀ alkyl, wherein one or more non-adjacent C atoms may be replaced with O, S, substituted N, C=O and -COO- and one or more H atoms of the alkyl group may be replaced with F;
NR⁹₂, OR⁹, SR⁹, SiR⁹₃ and
fluorine, nitro and cyano;
wherein each R⁹ is independently selected from the group consisting of alkyl, preferably C₁₋₂₀ alkyl; and aryl or heteroaryl, preferably phenyl, optionally substituted with one or more C₁₋₂₀ alkyl groups.

Substituted N, where present, may be -NR⁶- wherein R⁶ is a substituent and is optionally in each occurrence a C₁₋₄₀ hydrocarbyl group, optionally a C₁₋₂₀ alkyl group.

Preferably, each R⁷, where present, is independently selected from C₁₋₄₀hydrocarbyl, and is more preferably selected from C₁₋₂₀ alkyl; unsubstituted phenyl; phenyl substituted with one or more C₁₋₂₀ alkyl groups; a linear or branched chain of phenyl groups, wherein each phenyl may be unsubstituted or substituted with one or more substituents; and a crosslinkable group.

One preferred class of arylene repeat units is phenylene repeat units, such as phenylene repeat units of formula (VI): 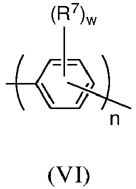 wherein w in each occurrence is independently 0, 1, 2, 3 or 4, optionally 1 or 2; n is 1, 2 or 3; and R⁷ independently in each occurrence is a substituent as described above.

If n is 1 then exemplary repeat units of formula (VI) include the following:

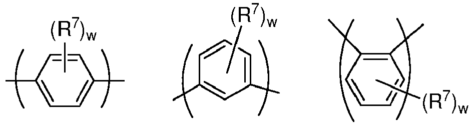

A particularly preferred repeat unit of formula (VI) has formula (VIa):

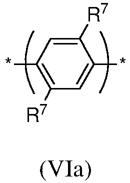

Substituents R⁷ of formula (VIa) are adjacent to linking positions of the repeat unit, which may cause steric hindrance between the repeat unit of formula (VIa) and adjacent repeat units, resulting in the repeat unit of formula (VIa) twisting out of plane relative to one or both adjacent repeat units.

Exemplary repeat units where n is 2 or 3 include the following:

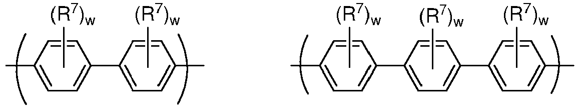

A preferred repeat unit has formula (VIb):

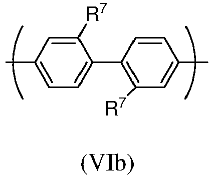

The two R⁷ groups of formula (VIb) may cause steric hindrance between the phenyl rings they are bound to, resulting in twisting of the two phenyl rings relative to one another.

A further class of arylene repeat units is optionally substituted fluorene repeat units, such as repeat units of formula (VII): 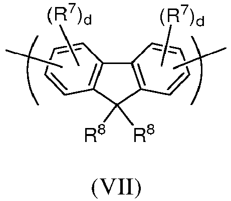 wherein R⁸ in each occurrence is the same or different and is a substituent wherein the two groups R⁸ may be linked to form a ring; R⁷ is a substituent as described above; and d is 0, 1, 2 or 3.

Each R⁸ may independently be selected from the group consisting of:
- alkyl, optionally C₁₋₂₀ alkyl, wherein one or more non-adjacent C atoms may be replaced with optionally substituted aryl or heteroaryl, O, S, substituted N, C=O or -COO-, and one or more H atoms may be replaced with F;
- aryl and heteroaryl groups that may be unsubstituted or substituted with one or more substituents, preferably phenyl substituted with one or more C₁₋₂₀ alkyl groups;
- a linear or branched chain of aryl or heteroaryl groups, each of which groups may independently be substituted, for example a group of formula -(Ar⁷)ᵣ wherein each Ar⁷ is independently an aryl or heteroaryl group and r is at least 2, optionally 2 or 3, preferably a branched or linear chain of phenyl groups each of which may be unsubstituted or substituted with one or more C₁₋₂₀ alkyl groups; and
- a crosslinkable-group, for example a group comprising a double bond such and a vinyl or acrylate group, or a benzocyclobutane group.

Preferably, each R⁸ is independently a C₁₋₄₀ hydrocarbyl group.

Substituted N, where present, may be -NR⁶- wherein R⁶ is as described above.

The aromatic carbon atoms of the fluorene repeat unit may be unsubstituted, or may be substituted with one or more substituents R⁷ as described with reference to Formula (VI).

Exemplary substituents R⁷ are alkyl, for example C₁₋₂₀ alkyl, wherein one or more non-adjacent C atoms may be replaced with O, S, C=O and -COO-, optionally substituted aryl, optionally substituted heteroaryl, alkoxy, alkylthio, fluorine, cyano and arylalkyl. Particularly preferred substituents include C₁₋₂₀ alkyl and substituted or unsubstituted aryl, for example phenyl. Optional substituents for the aryl include one or more C₁₋₂₀ alkyl groups.

The extent of conjugation of repeat units of formula (VII) to aryl or heteroaryl groups of adjacent repeat units in the polymer backbone may be controlled by (a) linking the repeat unit through the 3- and / or 6- positions to limit the extent of conjugation across the repeat unit, and / or (b) substituting the repeat unit with one or more substituents R⁸ in or more positions adjacent to the linking positions in order to create a twist with the adjacent repeat unit or units, for example a 2,7-linked fluorene carrying a C₁₋₂₀ alkyl substituent in one or both of the 3- and 6-positions.

The repeat unit of formula (VII) may be a 2,7-linked repeat unit of formula (VIIa):

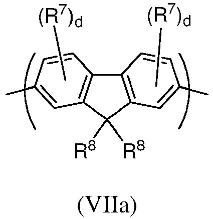

A relatively high degree of conjugation across the repeat unit of formula (VIIa) may be provided in the case where each d = 0, or where any substituent R7 is not present at a position adjacent to the linking 2- or 7-positions of formula (VIIa).

A relatively low degree of conjugation across the repeat unit of formula (VIIa) may be provided in the case where at least one d is at least 1, and where at least one substituent R⁷ is present at a position adjacent to the linking 2- or 7- positions of formula (VIIa). Optionally, each d is 1 and the 3- and / or 6- position of the repeat unit of formula (VIIa) is substituted with a substituent R⁷ to provide a relatively low degree of conjugation across the repeat unit.

The repeat unit of formula (VII) may be a 3,6-linked repeat unit of formula (VIIb)

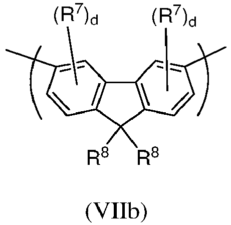

The extent of conjugation across a repeat unit of formula (VIIb) may be relatively low as compared to a corresponding repeat unit of formula (VIIa).

Another exemplary arylene repeat unit has formula (VIII): 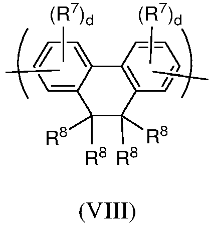 wherein R⁷, R⁸ and d are as described with reference to formula (VI) and (VII) above. Any of the R⁷ groups may be linked to any other of the R⁷ groups to form a ring. The ring so formed may be unsubstituted or may be substituted with one or more substituents, optionally one or more C₁₋₂₀ alkyl groups.

Repeat units of formula (VIII) may have formula (Villa) or (VIIIb): 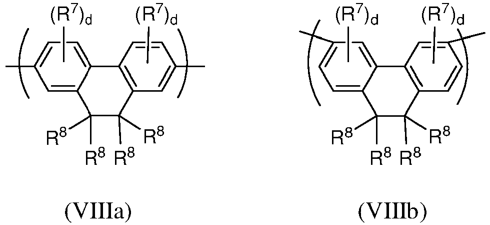 The one or more co-repeat units may include a conjugation-breaking repeat unit, which is a repeat unit that does not provide any conjugation path between repeat units adjacent to the conjugation-breaking repeat unit.

Exemplary conjugation-breaking co-repeat units include co-repeat units of formula (II): 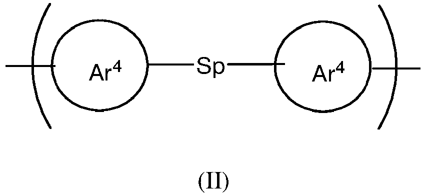 wherein:
Ar⁴ in each occurrence independently represents an aryl or heteroaryl group that may be unsubstituted or substituted with one or more substituents; and
Sp represents a spacer group comprising at least one carbon or silicon atom.

Preferably, the spacer group Sp includes at least one sp³-hybridised carbon atom separating the Ar⁴ groups.

Preferably Ar⁴ is an aryl group and the Ar⁴ groups may be the same or different. More preferably each Ar⁴ is phenyl.

Each Ar⁴ may independently be unsubstituted or may be substituted with 1, 2, 3 or 4 substituents. The one or more substituents may be selected from:
- C₁₋₂₀ alkyl wherein one or more non-adjacent C atoms of the alkyl group may be replaced by O, S or COO, C=O, NR⁶ or SiR⁶₂ and one or more H atoms of the C₁₋₂₀ alkyl group may be replaced by F wherein R⁶ is a substituent and is optionally in each occurrence a C₁₋₄₀ hydrocarbyl group, optionally a C₁₋₂₀ alkyl group; and
- aryl or heteroaryl, optionally phenyl, that may be unsubstituted or substituted with one or more C₁₋₂₀ alkyl groups.

Preferred substituents of Ar⁴ are C₁₋₂₀ alkyl groups, which may be the same or different in each occurrence.

Exemplary groups Sp include a C₁₋₂₀ alkyl chain wherein one or more non-adjacent C atoms of the chain may be replaced with O, S, -NR⁶-, -SiR⁶₂-, -C(=O)- or -COO- and wherein R⁶ in each occurrence is a substituent and is optionally in each occurrence a C₁₋₄₀ hydrocarbyl group, optionally a C₁₋₂₀ alkyl group.

Exemplary repeat units of formula (II) include the following, wherein R in each occurrence is H or C₁₋₅ alkyl:

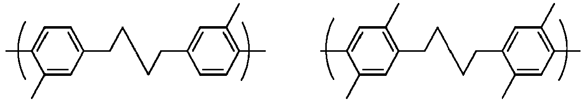

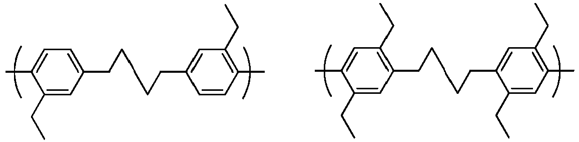

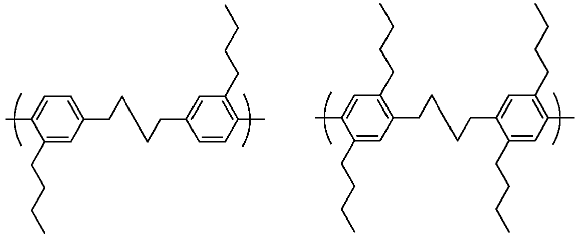

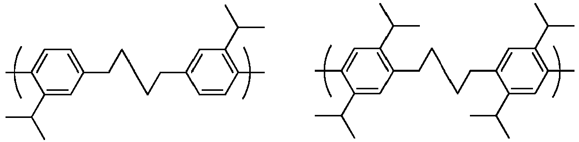

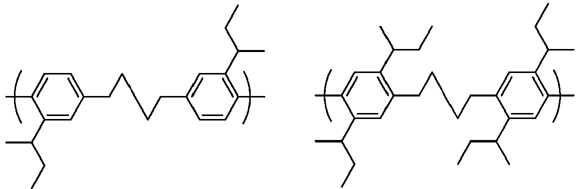

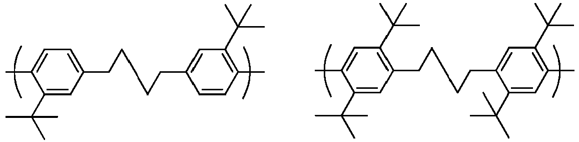

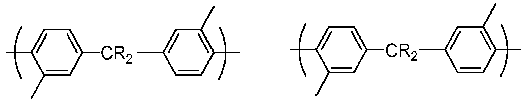

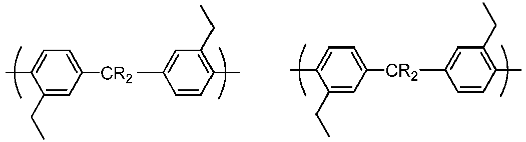

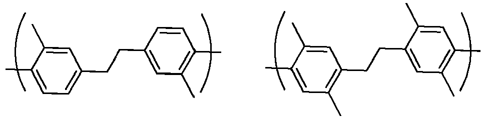

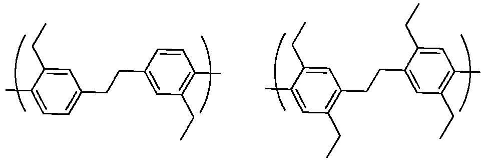

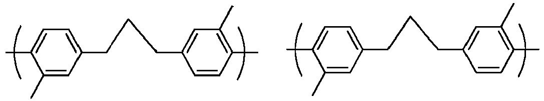

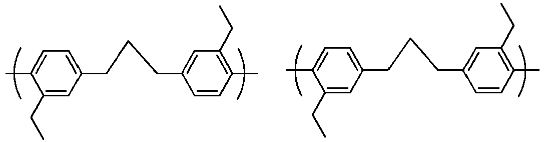

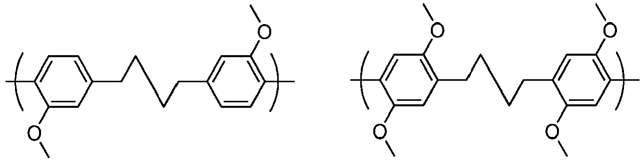

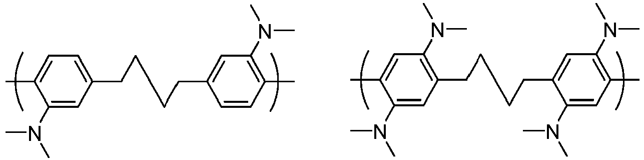

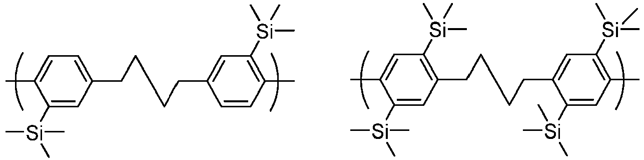

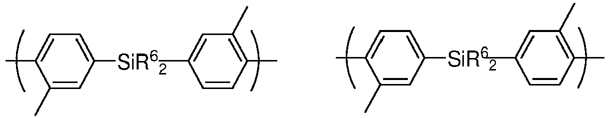

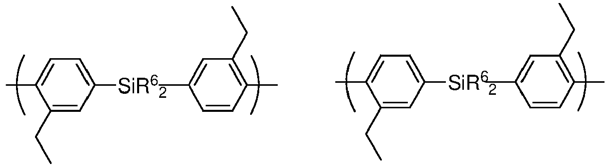

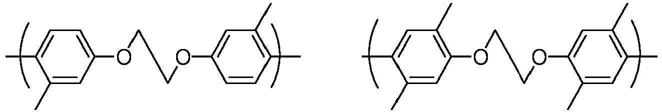

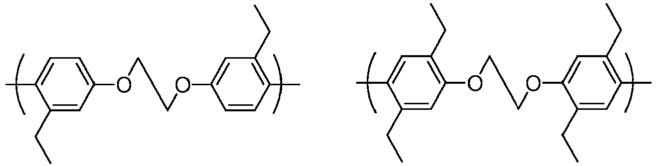

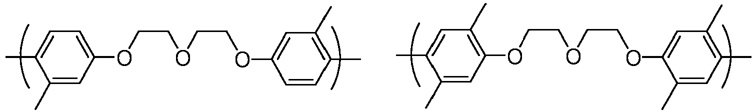

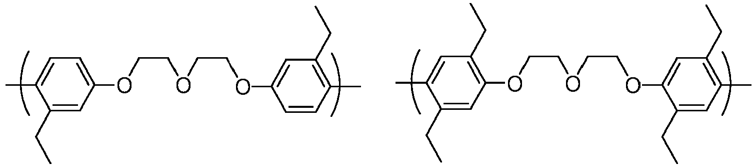

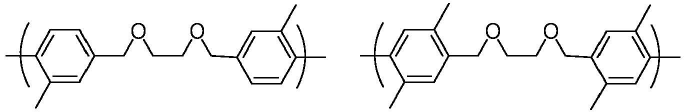

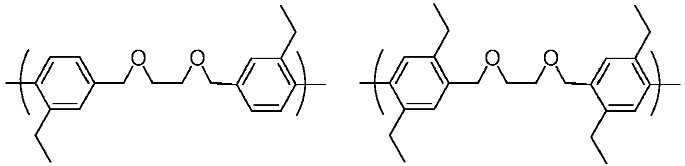

A hole-transporting polymer may contain one, two or more different repeat units of formula (III).

A hole-transporting polymer may contain crosslinkable groups that may be crosslinked following deposition of the hole-transporting polymer to form an insoluble, crosslinked hole-transporting layer prior to formation of the first light-emitting layer.

Crosslinkable groups may be provided as substituents of any repeat units of the polymer, for example any of repeat units (I), (II), (III), (VI), (VII) or (VIII) that may be present in the hole-transporting polymer.

Exemplary methods for forming conjugated hole-transporting polymers as described herein are by Suzuki polymerisation in the presence of a palladium catalyst and a base, and Yamamoto polymerisation in the presence of a nickel catalyst to form C-C bonds between two aromatic or heteroaromatic groups, and so form polymers having conjugation extending across two or more repeat units.

Yamamoto polymerisation may take place by polymerisation of monomers having two or more bromine or iodine substituents on an aryl or heteroaryl group of a monomer.

Suzuki polymerisation is described in WO 00/53656 or US 5777070 Suzuki polymerisation. As illustrated in Scheme 1, in the Suzuki polymerisation process a monomer for forming repeat units RU1 having leaving groups LG1 such as boronic acid or boronic ester groups undergoes polymerisation with a monomer for forming repeat units RU2 having leaving groups LG2 such as halogen, sulfonic acid or sulfonic ester to form a carbon-carbon bond between RU1 and RU2:

n LG1-RU1-LG1 + n LG2-RU2-LG2 → -(RU1-RU2)ₙ- Scheme 1

Preferably, one of LG1 and LG2 is bromine or iodine and the other is a boronic acid or boronic ester. One method of forming a polymer comprising more than 50 mol % hole-transporting repeat units is to polymerise monomers containing hole-transporting units having two or more leaving groups LG1 and monomers containing hole-transporting units having two or more leaving groups LG2, the total number of monomers containing hole-transporting units forming more than 50 mol % of all monomers.

It will be appreciated that Suzuki polymerisation may be used to form a homopolymer, or polymers containing two or more different repeat units.

A polymer containing more than 50 mol % of a hole-transporting repeat unit may be formed by Suzuki polymerisation of more than 25 mol % of a hole-transporting monomer having leaving groups LG1 and more than 25 mol % of a monomer having leaving groups LG2, or other combinations of monomers having leaving groups LG1 and monomers having leaving groups LG2 in which the number of hole-transporting monomers is greater than 50 mol %.

Polymers as described herein suitably have a polystyrene-equivalent number-average molecular weight (Mn) measured by gel permeation chromatography in the range of about 1×10³ to 1×10⁸, and preferably 1×10³ to 5×10⁶. The polystyrene-equivalent weight-average molecular weight (Mw) of the polymers described herein may be 1×10³ to 1×10⁸, and preferably 1×10⁴ to 1×10⁷.

The hole-transporting polymers as described anywhere herein are suitably amorphous polymers.

### Light-emitting compounds

The light-emitting material or materials of the first light-emitting layer and, if present of the hole-transporting layer may each independently be selected from fluorescent or phosphorescent materials.

Preferably, the second light-emitting material of the hole-transporting layer is a phosphorescent material. The second light-emitting material may be a phosphorescent hole-blocking light-emitting material.

Preferably, the first light-emitting material is a phosphorescent material.

Preferably, any further light-emitting materials of the first light-emitting layer are phosphorescent.

Phosphorescent light-emitting materials are preferably phosphorescent transition metal complexes.

Exemplary phosphorescent transition metal complexes have formula (IX):

ML¹_{q}L²ᵣL³ₛ (IX)

wherein M is a metal; each of L¹, L² and L³ is a coordinating group; q is a positive integer; r and s are each independently 0 or a positive integer; and the sum of (a. q) + (b. r) + (c.s) is equal to the number of coordination sites available on M, wherein a is the number of coordination sites on L¹, b is the number of coordination sites on Land c is the number of coordination sites on L³. Preferably, a, b and c are each 1 or 2, more preferably 2 (bidentate ligand). In preferred embodiments, q is 2, r is 0 or 1 and s is 0, or q is 3 and r and s are each 0.

Heavy elements M induce strong spin-orbit coupling to allow rapid intersystem crossing and emission from triplet or higher states. Suitable heavy metals M include d-block metals, in particular those in rows 2 and 3 i.e. elements 39 to 48 and 72 to 80, in particular ruthenium, rhodium, palladium, rhenium, osmium, iridium, platinum and gold. Iridium is particularly preferred.

Exemplary ligands L¹, L² and L³ include carbon or nitrogen donors such as porphyrin or bidentate ligands of formula (X): 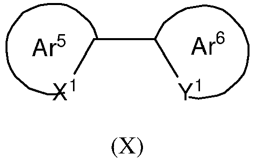 wherein Ar⁵ and Ar⁶ may be the same or different and are independently selected from substituted or unsubstituted aryl or heteroaryl; X¹ and Y¹ may be the same or different and are independently selected from carbon or nitrogen; and Ar⁵ and Ar⁶ may be fused together. Ligands wherein X¹ is carbon and Y¹ is nitrogen are preferred, in particular ligands in which Ar⁵ is a single ring or fused heteroaromatic of N and C atoms only, for example pyridyl or isoquinoline, and Ar⁶ is a single ring or fused aromatic, for example phenyl or naphthyl.

The HOMO and LUMO levels of a light-emitting material may be modified by selection of substituents of the light-emitting material and / or substituent position. HOMO and / or LUMO levels of a material may be deepened (moved further from vacuum) by use of one or more electron-withdrawing substituents, for example one or more substituents having a positive Hammett constant. HOMO and / or LUMO levels of a material may be moved closer to vacuum by use of one or more electron-donating substituents, for example one or more substituents having a negative Hammett constant.

A hole-blocking light-emitting material may be unsubstituted, substituted with one or more electron-withdrawing substituents only or substituted with one or more electron-withdrawing substituents and one or more further substituents, for example one or more C₁₋₄₀ hydrocarbyl groups.

An exemplary hole-blocking light-emitting material has the following structure:

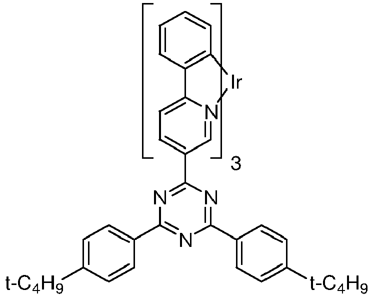

Preferably, the first light-emitting material and any further light-emitting materials of the first light-emitting layer has a LUMO level that is closer to vacuum that the LUMO of the second light-emitting material, optionally at least 0.1 eV or at least 0.2 eV closer.

Exemplary blue phosphorescent first light-emitting materials having a shallow HOMO level suitable for providing a HOMO level shallower than that of the hole-transporting polymer are compounds of formula (IX) wherein L¹ is arylimidazole or aryltriazole, optionally phenylimidazole or phenyltriazole, that is substituted with one or more C₁₋₄₀ hydrocarbyl groups; L¹ is at least 1, preferably 2 or 3; and L² and L³ are each independently 0 or 1, preferably 0.

To achieve red emission, Ar⁵ may be selected from phenyl, fluorene, naphthyl and Ar⁶ are selected from quinoline, isoquinoline, thiophene and benzothiophene.

To achieve green emission, Ar⁵ may be selected from phenyl or fluorene and Ar⁶ may be pyridine.

To achieve blue emission, Ar⁵ may be phenyl and Ar⁶ may be selected from imidazole, pyrazole, triazole and tetrazole.

Examples of bidentate ligands are illustrated below: 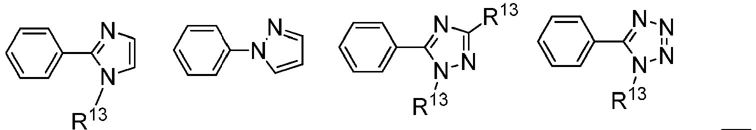 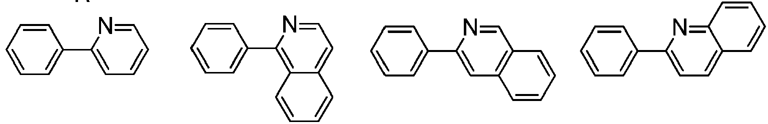 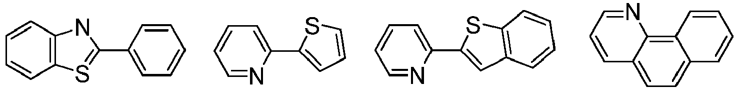 wherein R¹³ is as described above with reference to formula (III). Preferred R¹³ groups of ligands illustrated above are C₁₋₂₀ alkyl; C₁₋₂₀ aryl or C₁₋₂₀ biaryl groups, optionally phenyl or biphenyl, wherein the or each C₁₋₂₀ aryl group may independently be unsubstituted or substituted with one or more substituents, optionally one or more C₁₋₂₀ alkyl and C₁₋₂₀ alkoxy groups; and dendrimers as described below.

Other ligands suitable for use with d-block elements include diketonates, in particular acetylacetonate (acac), tetrakis-(pyrazol-1-yl)borate, 2-carboxypyridyl, triarylphosphines and pyridine, each of which may be substituted.

Each of Ar⁵ and Ar⁶ may carry one or more substituents. Two or more of these substituents may be linked to form a ring, for example an aromatic ring.

Exemplary substituents include groups R⁷ as described above with reference to Formula (I). Particularly preferred substituents include fluorine or trifluoromethyl which may be used to blue-shift the emission of the complex, for example as disclosed in WO 02/45466, WO 02/44189, US 2002-117662 and US 2002-182441; alkyl or alkoxy groups, for example C₁₋₂₀ alkyl or alkoxy, which may be as disclosed in JP 2002-324679; charge transporting groups, for example carbazole which may be used to assist hole transport to the complex when used as an emissive material, for example as disclosed in WO 02/81448; C₁₋₂₀ aryl or C₁₋₂₀ biaryl groups, optionally phenyl or biphenyl, wherein the or each C1-20 aryl group may independently be unsubstituted or substituted with one or more substituents, optionally one or more C₁₋₂₀ alkyl and C₁₋₂₀ alkoxy groups; and dendrons which may be used to obtain or enhance solution processability of the metal complex, for example as disclosed in WO 02/66552. If substituents R⁷ include a charge-transporting group then the compound of formula (IX) may be used in light-emitting layer 107 without a separate host material.

A light-emitting dendrimer comprises a light-emitting core bound to one or more dendrons, wherein each dendron comprises a branching point and two or more dendritic branches. Preferably, the dendron is at least partially conjugated, and at least one of the branching points and dendritic branches comprises an aryl or heteroaryl group, for example a phenyl group. In one arrangement, the branching point group and the branching groups are all phenyl, and each phenyl may independently be substituted with one or more substituents, for example alkyl or alkoxy.

A dendron may have optionally substituted formula (XI) 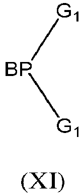 wherein BP represents a branching point for attachment to a core and G₁ represents first generation branching groups.

The dendron may be a first, second, third or higher generation dendron. G₁ may be substituted with two or more second generation branching groups G₂, and so on, as in optionally substituted formula (XIa): 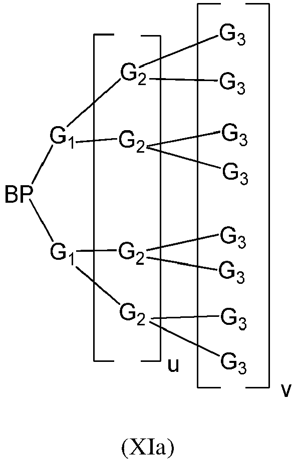 wherein u is 0 or 1; v is 0 if u is 0 or may be 0 or 1 if u is 1; BP represents a branching point for attachment to a core and G₁, G₂ and G₃ represent first, second and third generation dendron branching groups. In one preferred embodiment, each of BP and G₁, G₂ ... Gₙ is phenyl, and each phenyl BP, G₁, G₂ ... Gₙ₋₁ is a 3,5-linked phenyl.

In another preferred embodiment, BP is an electron-deficient heteroaryl, for example pyridine, 1,3-diazine, 1,4-diazine, 1,2,4-triazine or 1,3,5-triazine and G₂ ... Gₙ is an aryl group, optionally phenyl.

Preferred dendrons are a substituted or unsubstituted dendron of formulae (XIb) and (XIc): 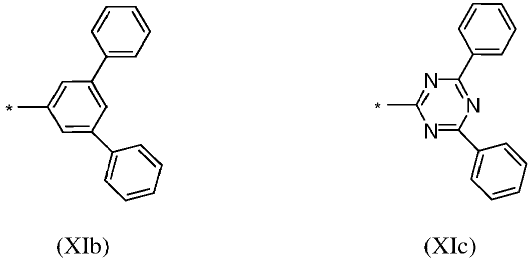 wherein * represents an attachment point of the dendron to a core.

BP and / or any group G may be substituted with one or more substituents, for example one or more C₁₋₂₀ alkyl or alkoxy groups.

The phosphorescent material may be covalently bound to a host material of or may be mixed with a host material.

A phosphorescent hole-blocking material in the hole-transporting layer may be covalently bound to the hole-transporting polymer.

The phosphorescent material may be covalently bound to a host polymer or a hole-transporting polymer as a repeat unit in the polymer backbone, as an end-group of the polymer, or as a side-chain of the polymer. If the phosphorescent material is provided as a side-chain then it may be directly bound to a repeat unit in the backbone of the polymer or it may be spaced apart from the polymer backbone by a spacer group. Exemplary spacer groups include C₁₋₂₀ alkyl and aryl-C₁₋₂₀ alkyl, for example phenyl-C₁₋₂₀ alkyl. One or more carbon atoms of an alkyl group of a spacer group may be replaced with O, S, C=O or COO. A phosphorescent material of a hole-transporting layer or the light-emitting layer 107, and optional spacer, may be provided as a substituent of any of repeat units of formulae (I), (II), (III), (IV), (VI), (VII) or (VIII) described above that may be present in a hole-transporting polymer or host polymer.

Covalent binding of the phosphorescent material to a hole-transporting polymer may reduce or avoid washing of the phosphorescent material out of the hole-transporting layer if an overlying layer is deposited from a formulation of the overlying layer's materials in a solvent or solvent mixture.

A phosphorescent material mixed with a host material or hole-transporting polymer may form 0.1 - 50 weight %, optionally 0.1 - 30 wt % of the weight of the components of the layer containing the phosphorescent material.

If the phosphorescent material is covalently bound to a hole-transporting polymer then repeat units comprising the phosphorescent material, or an end unit comprising the phosphorescent material, may form 0.1-20 mol %, optionally 0.1-5 mol % or 0.1-3 mol % of the polymer.

If two or more phosphorescent materials are provided in the first light emitting layer then the phosphorescent material with the highest triplet energy level is preferably provided in a larger weight percentage than the lower triplet energy level material or materials.

### First light-emitting layer

Light-emitting materials provided in the first light-emitting layer 107 may be polymeric or non-polymeric light-emitting materials, and may be fluorescent or phosphorescent light-emitting materials.

A phosphorescent first light-emitting layer 107 may contain a host material in addition to at least one phosphorescent light-emitting material. The host material may be a non-polymeric or polymeric material. The host material preferably has a triplet energy level that is the same as or higher than the triplet energy level or levels of the one or more phosphorescent materials.

The host material may be an electron-transporting material to provide for efficient transport of electrons from the cathode into the first light-emitting layer 107, either directly if the light-emitting layer 107 is in direct contact with the cathode or, if present, via one or more intervening electron-transporting or electron injecting layers. The host material may have a LUMO level in the range of about -2.8 to -1.6 eV.

Host polymers include polymers having a non-conjugated backbone with charge-transporting groups pendant from the polymer backbone, and polymers having a conjugated backbone in which adjacent repeat units of the polymer backbone are conjugated together. A conjugated host polymer may comprise, without limitation, repeat units selected from optionally substituted arylene or heteroarylene repeat units including any of the arylene (I), (VI), (VII) and (VIII) described above; conjugation-breaking repeat units of formula (II) as described above; and amine repeat units of formula (III) as described above.

The host polymer may contain triazine-containing repeat units. Exemplary triazine-containing repeat units have formula (IV): 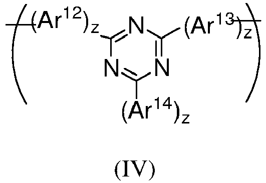 wherein Ar¹², Ar¹³ and Ar¹⁴ are independently selected from substituted or unsubstituted aryl or heteroaryl, and z in each occurrence is independently at least 1, optionally 1, 2 or 3, preferably 1.

Any of Ar¹², Ar¹³ and Ar¹⁴ may be substituted with one or more substituents. Exemplary substituents are substituents R¹⁰, wherein each R¹⁰ may independently be selected from the group consisting of:
- substituted or unsubstituted alkyl, optionally C₁₋₂₀ alkyl, wherein one or more non-adjacent C atoms may be replaced with optionally substituted aryl or heteroaryl, O, S, substituted N, C=O or -COO- and one or more H atoms may be replaced with F; and
- a crosslinkable group attached directly to Ar¹², Ar¹³ and Ar¹⁴ or spaced apart therefrom by a spacer group, for example a group comprising a double bond such and a vinyl or acrylate group, or a benzocyclobutane group.

Substituted N, where present, may be -NR⁶- wherein R⁶ is a substituent as described above.

Preferably, Ar¹², Ar¹³ and Ar¹⁴ of formula (VIII) are each phenyl, each phenyl independently being unsubstituted or substituted with one or more C₁₋₂₀ alkyl groups.

Ar¹⁴ of formula (IV) is preferably phenyl, and is optionally substituted with one or more C₁₋₂₀ alkyl groups or a crosslinkable unit.

A particularly preferred repeat unit of formula (IV) has formula (IVa).

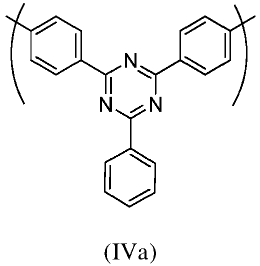

The repeat unit of formula (IVa) be unsubstituted or substituted with one or more substituents R¹⁰ as described above with respect to formula (IV), preferably one or more C₁₋₂₀ alkyl groups.

The host polymer may comprise repeat units of formula (V): 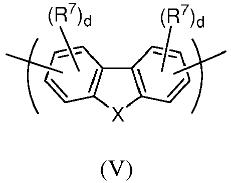 wherein R⁷ is a substituent as described with reference to formula (I) and d is 0, 1, 2 or 3, and X is O or S.

### HOMO and LUMO level measurement

HOMO and LUMO levels as described anywhere herein may be measured by square wave voltammetry.

The working electrode potential may be ramped linearly versus time. When square wave voltammetry reaches a set potential the working electrode's potential ramp is inverted. This inversion can happen multiple times during a single experiment. The current at the working electrode is plotted versus the applied voltage to give the cyclic voltammogram trace.

Apparatus to measure HOMO or LUMO energy levels by CV may comprise a cell containing a tert-butyl ammonium perchlorate/ or tertbutyl ammonium hexafluorophosphate solution in acetonitrile, a glassy carbon working electrode where the sample is coated as a film, a platinum counter electrode (donor or acceptor of electrons) and a reference glass electrode no leak Ag/AgCl. Ferrocene is added in the cell at the end of the experiment for calculation purposes.

Measurement of the difference of potential between Ag/AgCl/ferrocene and sample/ferrocene.

Method and settings:
3mm diameter glassy carbon working electrode
Ag/AgCl/no leak reference electrode
Pt wire auxiliary electrode
0.1 M tetrabutylammonium hexafluorophosphate in acetonitrile
LUMO = 4.8 - ferrocene (peak to peak maximum average) + onset

Sample: 1 drop of 5mg/mL in toluene spun at 3000rpm LUMO (reduction) measurement: A good reversible reduction event is typically observed for thick films measured at 200 mV/s and a switching potential of -2.5V. The reduction events should be measured and compared over 10 cycles, usually measurements are taken on the 3^{rd} cycle. The onset is taken at the intersection of lines of best fit at the steepest part of the reduction event and the baseline. HOMO and LUMO values may be measured at ambient temperature.

### Hole injection layers

A hole injection layer may be provided between the anode 103 and the hole-transporting layer 105. A first surface of the hole-injection layer is preferably in contact with the anode. A second, opposing surface of the hole-injection layer may be in contact with the hole-transporting layer 105, or may be spaced apart therefrom, for example spaced apart therefrom by a hole-transporting layer. The hole-injection layer may be formed from a conductive organic or inorganic material, and may be formed from a degenerate semiconductor.

Examples of conductive organic materials include optionally substituted, doped poly(ethylene dioxythiophene) (PEDT), in particular PEDT doped with a charge-balancing polyacid such as polystyrene sulfonate (PSS) as disclosed in EP 0901176 and EP 0947123, polyacrylic acid or a fluorinated sulfonic acid, for example Nafion ^{®}; polyaniline as disclosed in US 5723873 and US 5798170; and optionally substituted polythiophene or poly(thienothiophene). Examples of conductive inorganic materials include transition metal oxides such as VOx, MoOx and RuOx as disclosed in Journal of Physics D: Applied Physics (1996), 29(11), 2750-2753.

### Cathode

The cathode 109 is selected from materials that have a work function allowing injection of electrons into the first light-emitting layer 107 of the OLED. Other factors influence the selection of the cathode such as the possibility of adverse interactions between the cathode and the light-emitting material. The cathode may consist of a single material such as a layer of aluminium. Alternatively, it may comprise a plurality of conductive materials such as metals, for example a bilayer of a low work function material and a high work function material such as calcium and aluminium, for example as disclosed in WO 98/10621. The cathode may comprise elemental barium, for example as disclosed in WO 98/57381, Appl. Phys. Lett. 2002, 81(4), 634 and WO 02/84759. The cathode may comprise a thin, preferably 0.5 - 5 nm, layer of metal compound, in particular an oxide or fluoride of an alkali or alkali earth metal, between the organic layers of the device and one or more conductive cathode layers to assist electron injection, for example lithium fluoride as disclosed in WO 00/48258; barium fluoride as disclosed in Appl. Phys. Lett. 2001, 79(5), 2001; and barium oxide. In order to provide efficient injection of electrons into the device, the cathode preferably has a work function of less than 3.5 eV, more preferably less than 3.2 eV, most preferably less than 3 eV. Work functions of metals can be found in, for example, Michaelson, J. Appl. Phys. 48(11), 4729, 1977.

The cathode may be opaque or transparent. Transparent cathodes are particularly advantageous for active matrix devices because emission through a transparent anode in such devices is at least partially blocked by drive circuitry located underneath the emissive pixels. A transparent cathode comprises a layer of an electron injecting material that is sufficiently thin to be transparent. Typically, the lateral conductivity of this layer will be low as a result of its thinness. In this case, the layer of electron injecting material is used in combination with a thicker layer of transparent conducting material such as indium tin oxide.

It will be appreciated that a transparent cathode device need not have a transparent anode (unless, of course, a fully transparent device is desired), and so the transparent anode used for bottom-emitting devices may be replaced or supplemented with a layer of reflective material such as a layer of aluminium. Examples of transparent cathode devices are disclosed in, for example, GB 2348316.

### Encapsulation

Organic optoelectronic devices tend to be sensitive to moisture and oxygen. Accordingly, the substrate preferably has good barrier properties for prevention of ingress of moisture and oxygen into the device. The substrate is commonly glass, however alternative substrates may be used, in particular where flexibility of the device is desirable. For example, the substrate may comprise one or more plastic layers, for example a substrate of alternating plastic and dielectric barrier layers or a laminate of thin glass and plastic.

The device may be encapsulated with an encapsulant (not shown) to prevent ingress of moisture and oxygen. Suitable encapsulants include a sheet of glass, films having suitable barrier properties such as silicon dioxide, silicon monoxide, silicon nitride or alternating stacks of polymer and dielectric or an airtight container. In the case of a transparent cathode device, a transparent encapsulating layer such as silicon monoxide or silicon dioxide may be deposited to micron levels of thickness, although in one preferred embodiment the thickness of such a layer is in the range of 20-300 nm. A getter material for absorption of any atmospheric moisture and / or oxygen that may permeate through the substrate or encapsulant may be disposed between the substrate and the encapsulant.

### Formulation processing

A formulation suitable for forming the hole-transporting layer and the first light-emitting layer may be formed from the components forming those layers and one or more suitable solvents.

The formulation may be a solution of the components of the layer in question, or may be a dispersion in the one or more solvents in which one or more components are not dissolved. Preferably, the formulation is a solution.

Exemplary solvents include benzenes substituted with one or more substituents selected from C₁₋₁₀ alkyl and C₁₋₁₀ alkoxy groups, for example toluene, xylenes and methylanisoles.

Particularly preferred solution deposition techniques including printing and coating techniques such spin-coating and inkjet printing.

Coating methods are particularly suitable for devices wherein patterning of the light-emitting layer is unnecessary - for example for lighting applications or simple monochrome segmented displays.

Printing methods are particularly suitable for high information content displays, in particular full colour displays. A device may be inkjet printed by providing a patterned layer over the anode and defining wells for printing of one colour (in the case of a monochrome device) or multiple colours (in the case of a multicolour, in particular full colour device). The patterned layer is typically a layer of photoresist that is patterned to define wells as described in, for example, EP 0880303.

As an alternative to wells, the ink may be printed into channels defined within a patterned layer. In particular, the photoresist may be patterned to form channels which, unlike wells, extend over a plurality of pixels and which may be closed or open at the channel ends.

Other solution deposition techniques include dip-coating, slot die coating, roll printing and screen printing.

Preferably one or both of the hole-transporting polymers carries crosslinkable groups that are reacted following deposition of the hole-transporting polymer to form a crosslinked hole-transporting layer. The polymer may be crosslinked by thermal treatment or by irradiation, for example UV irradiation. Thermal crosslinking may be at a temperature in the range of about 80-250°C, optionally about 80 - 200°C or about 150-200°C.

### Examples

### Materials

Polymers were formed by Suzuki polymerisation as described in WO 00/53656.

Hole-Transporting Light-Emitting Polymer 1 (not forming part of the claimed invention) was formed by polymerisation of monomers for forming 30 mol % of crosslinkable repeat units of formula (VIa); 67 mol % of repeat units of formula (III-1) wherein Ar⁹ is fluorene and 3 mol % of a light-emitting repeat unit formed from Monomer 1. The polymer had a Mz value of 1,800,000, Mw of 580,000, Mp of 230,000, Mn of 32,000 and Pd of 18.47.

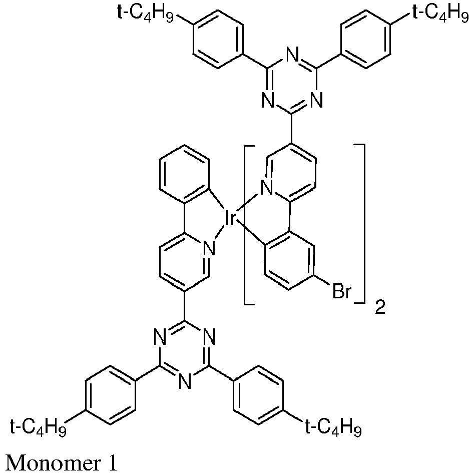

For comparison, Comparative Polymer 1 was prepared. Comparative Polymer 1 had a Mz value of 2,465,000, Mw of 774,000, Mp of 247,000, Mn of 43,000and Pd of 18.19.

Hole-Transporting Polymer 1 (not forming part of the claimed invention) was formed by polymerisation of monomers for forming 90 mol % repeat units of formula (III-1) wherein Ar⁹ is fluorene and 10 mol % of crosslinkable units of formula (VIIa).

Comparative Polymer 1 and Light-Emitting Polymer 1 both contain a phosphorescent hole-blocking repeat unit formed by polymerisation of Monomer 5.

Phosphorescent red-emitting Monomer 1 has a HOMO level of -5.32 eV and a LUMO level of -2.9 eV.

With reference to Table 2, both the HOMO and LUMO levels of Monomer 1 are deeper than the HOMO and LUMO levels of any of Comparative Polymer 1, Hole-Transporting Light-Emitting Polymer 1 and Hole-Transporting Polymer 1.

Although Comparative Polymer 1 and Hole-Transporting Light-Emitting Polymer 1 both contain a repeat unit derived from hole-blocking Monomer 1, the small amount of this material in the polymer has little or no effect on the HOMO level of the polymer.

**Table 2**

| Polymer | LUMO (eV) | HOMO (eV) |
|---|---|---|
| Comparative Polymer 1 | < -1.9 | -5.16 |
| Hole-Transporting Light-Emitting Polymer 1 | < -1.9 | -5.17 |
| Hole-Transporting Polymer 1 | -2.17 | -5.2 |

### Hole-only device

A hole-only device having the following structure was prepared:
ITO / HIL / HTL / Cathode
wherein ITO is an indium-tin oxide anode; HIL is a hole-injecting layer; and HTL is a hole-transporting layer.

A substrate carrying ITO was cleaned using UV / Ozone. The hole injection layer was formed to a thickness of 65 nm by spin-coating an aqueous formulation of a hole-injection material available from Plextronics, Inc. A hole transporting layer was formed to a thickness of 60 nm by spin-coating Light-Emitting Polymer 1 or Comparative Polymer 1. A cathode was formed by evaporation of a first layer of aluminium and a second layer of silver.

With reference to Figure 4, current density is higher for the device containing Light-Emitting Polymer 1 than for the device containing Comparative Polymer 1. Without wishing to be bound by any theory, it is believed that the higher amine content of Light-Emitting Polymer 1 offsets the hole-blocking effect of the hole-blocking phosphorescent repeat unit present in Light-Emitting Polymer 1 and Comparative Polymer 1.

Device Example 1 (not forming part of the claimed invention)

A white organic light-emitting device having the following structure was prepared:
ITO / HIL / HTL / LE1 / EIL / Cathode
wherein ITO is an indium-tin oxide anode; HIL is a hole-injecting layer; HTL is a hole-transporting, light-emitting layer; LE1 is a first light-emitting layer; and EIL is an electron-injecting layer.

A substrate carrying ITO was cleaned using UV / Ozone. The hole injection layer was formed to a thickness of about 65 nm by spin-coating an aqueous formulation of a hole-injection material available from Plextronics, Inc. A hole-transporting light-emitting layer was formed to a thickness of about 20 nm by spin-coating Light-Emitting Polymer 1 and crosslinking the polymer by heating. A first light-emitting layer was formed to a thickness of 75 nm by spin-coating a composition of Host 1 (74 wt %), Green Phosphorescent Emitter 1 (1 wt %) and Blue Phosphorescent Emitter 1 (25 wt %). An electron-injecting layer was formed by spin coating an electron-transporting polymer comprising dihexylphenylene repeat units and the cesium salt of electron-transporting unit 1 as described in WO 2012/133229 to a thickness of 10 nm.

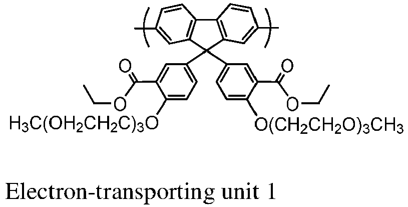

A cathode was formed by evaporation of a first layer of sodium fluoride to a thickness of about 2 nm, a second layer of aluminium to a thickness of about 100 nm and a third layer of silver to a thickness of about 100 nm.

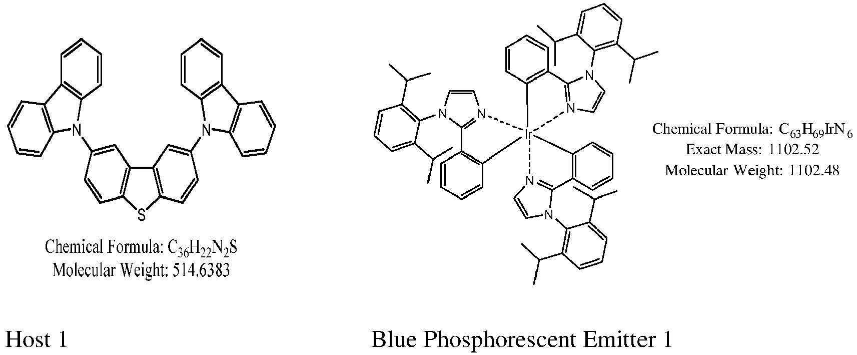

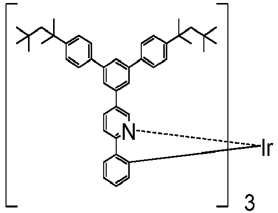

### Green Phosphorescent Emitter 1

Blue Phosphorescent Emitter 1 has a HOMO level of -4.82 eV.

Green Phosphorescent Emitter 1 has a HOMO level of -5.17 eV.

### Comparative Device 1

For the purpose of comparison, a device was formed as described for Device Example 1 except that Light-Emitting Polymer 1 was replaced with Comparative Polymer 1.

### Device Example 2 (not forming part of the claimed invention)

A device was prepared as described in Device Example 1 except that a hole-transporting layer was formed between the hole-injection layer and the hole-transporting light-emitting layer by spin-coating Hole-Transporting Polymer 1 to a thickness of about 10 nm, and the hole-transporting light-emitting layer was formed to a thickness of about 10 nm.

With reference to Table 2, drive voltage required to reach a current density of 10 mA/cm² or to reach a brightness of 1000 cd/m² is lower for Device Example 1 than for Comparative Device 1. External quantum efficiency and efficiency measured in lumens per watt at 1000 cd/m² are higher for Device Example 1.

Without wishing to be bound by any theory, it is believed that the high amine hole-transporting unit content of Light-Emitting Polymer 1 offsets the hole-blocking effect of the phosphorescent hole-blocking material in this layer.

Inclusion of a hole-transporting layer formed from Hole-Transporting Polymer 1 having a high amine hole-transporting unit content had little or no effect on device performance, indicating that the high amine content of Light-Emitting Polymer 1 alone is sufficient to offset the hole-blocking effect of the phosphorescent hole-blocking material.

**Table 2**

| ***Device*** | ***Hole-transporting layer*** | ***Amine content of hole-transporting polymer (mol* %)** | ***V at 10mAcm-*2** | ***V at 1000 cd*/*m²* (V)** | ***EQE at 1000 cd*/*m²* (%)** | ***Efficiency at 1000 cd*/*m² (Lm*/*W)*** |
|---|---|---|---|---|---|---|
| Device Example 1 | Hole-Transporting Light-Emitting Polymer 1 | 67 | 5.1 | 4.2 | 15.7 | 29 |
| Comparative Device 1 | Comparative Polymer 1 | 47 | 6.3 | 5.3 | 14.6 | 22 |
| Device Example 2 | Hole-Transporting Polymer 1 | 67 | 5.1 | 4.2 | 15.5 | 29 |

### Comparative Devices 3A and 3B

A white organic light-emitting device having the following structure was prepared:
ITO / HIL / HTL / LE1 / EIL / Cathode

A substrate carrying ITO was cleaned using UV / Ozone. The hole injection layer was formed to a thickness of about 65 nm by spin-coating an aqueous formulation of a hole-injection material available from Plextronics, Inc. A hole-transporting light-emitting layer was formed to a thickness of about 20 nm by spin-coating Light-Emitting Polymer 1 or Comparative Polymer 1 and crosslinking the polymer by heating. A first light-emitting layer was formed to a thickness of 75 nm by spin-coating a composition containing Blue Phosphorescent Emitter 2 (12 wt %) and Green Phosphorescent Emitter 1 (1 wt %). An electron-injecting layer was formed by spin coating an electron-transporting polymer.

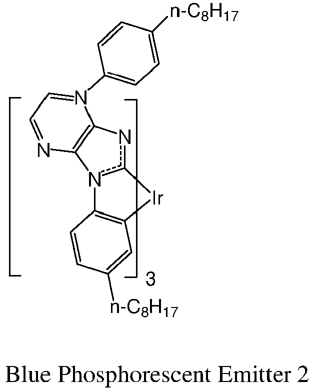

A cathode was formed by evaporation of a first layer of sodium fluoride to a thickness of about 2 nm, a second layer of aluminium to a thickness of about 100 nm and a third layer of silver to a thickness of about 100 nm.

Blue Phosphorescent Emitter 2 has a HOMO level of 5.72 eV, which is deeper than either Light-Emitting Polymer 1 or Comparative Polymer 1.

With reference to Table 3, use of Hole-Transporting Light-Emitting Polymer 1 (67 mol % amine) in place of Comparative Polymer 1 (47 mol % amine) results in a fall in both external quantum efficiency and efficiency measured in lumens per watt when this polymer is used with Blue Phosphorescent Emitter 2.

| **Device** | **Hole-transporting layer** | **Amine content of hole-transporting polymer (mol %)** | **V at 10mAcm-2** | **V at 1000 cd/m² (V)** | **EQE at 1000 cd/m² (%)** | **Efficiency at 1000 cd/m² (Lm/W)** |
|---|---|---|---|---|---|---|
| Comparative Device 3A | Hole-Transporting Light-Emitting Polymer 1 | 67 | 5.8 | 5.0 | 12.1 | 17 |
| Comparative Device 3B | Comparative Polymer 1 | 47 | 6.4 | 5.2 | 15.5 | 23 |

Although the present invention has been described in terms of specific exemplary embodiments, it will be appreciated that various modifications, alterations and/or combinations of features disclosed herein will be apparent to those skilled in the art without departing from the scope of the invention as set forth in the following claims.

## Claims

1. An organic light-emitting device (100) comprising an anode (103); a cathode (109); a first light-emitting layer (107) comprising a first light-emitting material between the anode (103) and the cathode (109); and a hole-transporting layer (105) comprising a hole-transporting copolymer between the anode (103) and the first light-emitting layer (107) and adjacent to the first light-emitting layer, wherein a HOMO level of the first light-emitting material is closer to vacuum than a HOMO level of the hole-transporting copolymer and wherein 55-95 mol % of the repeat units of the hole-transporting copolymer are hole-transporting repeat units of formula (III): 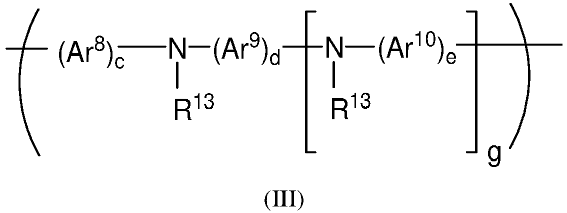 wherein Ar⁸, Ar⁹ and Ar¹⁰ in each occurrence are independently selected from substituted or unsubstituted phenylene; g is 0 or 1, R¹³ is H or a substituent; c, d and e are each independently 1; and any two aromatic or heteroaromatic groups bound directly to the same N atom may be linked by a direct bond or divalent linking group; and wherein the hole transporting copolymer further comprises an arylene co-repeat unit which is unsubstituted or substituted with one or more substituents.

2. The organic light-emitting device according to claim 1 wherein the hole-transporting layer (105) further comprises a hole-blocking light-emitting material.

3. The organic light-emitting device according to claim 1 or 2 wherein the first light-emitting material is a phosphorescent light-emitting material.

4. The organic light-emitting device according to any preceding claim wherein the hole-transporting repeat units include two or more different hole-transporting repeat units.

5. The organic light-emitting device according to any preceding claim wherein the first light-emitting material is a green or a blue light-emitting material.

6. The organic light-emitting device according to any preceding claim wherein substantially all light emitted from the device is phosphorescence.

7. The organic light-emitting device according to any preceding claim wherein the device is a white light-emitting device.

8. The organic light-emitting device according to any one of the preceding claims wherein the arylene co-repeat unit is selected from 1,3-phenylene; 1,4-phenylene; 3,6-linked fluorene; 2,7- linked fluorene; indenofluorene; 1,4-linked naphthalene; 2,6-linked naphthalene; 9,10-linked anthracene; 2,6-linked anthracene; and phenanthrene.

9. The organic light-emitting device according to any preceding claim wherein a conductive hole-injection layer is provided between the anode (103) and the first light-emitting layer.

10. A method of forming an organic light-emitting device according to any preceding claim comprising the steps of forming the hole-transporting layer (105) over the anode (103); forming the first light-emitting layer (107) on the hole-transporting layer (105); and forming the cathode (109) over the first light-emitting layer, wherein the hole-transporting layer (105) and the first light-emitting layer (107) are each formed by depositing a formulation comprising the material or materials of each said layer and at least one solvent and evaporating the at least one solvent.

11. The method according to claim 10 wherein the hole-transporting layer (105) is crosslinked prior to formation of the first light-emitting layer.

12. An organic light-emitting device comprising an anode (103); a cathode (109); a first light-emitting layer (107) between the anode (103) and the cathode (109); a hole-transporting light-emitting layer between the anode (103) and the first light-emitting layer (107) comprising a hole-blocking light-emitting material and a hole-transporting copolymer, wherein 55-95 mol % of the repeat units of the hole-transporting copolymer are hole-transporting repeat units of formula (III): 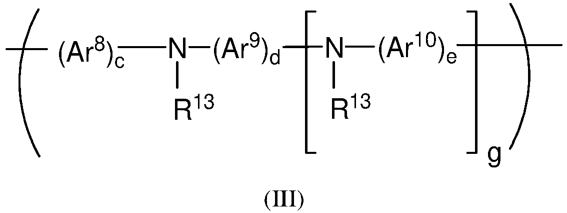 wherein Ar⁸, Ar⁹ and Ar¹⁰ in each occurrence are independently selected from substituted or unsubstituted phenylene, g is 0 or 1, R¹³ is H or a substituent; c, d and e are each independently 1, 2 or 3; and any two aromatic or heteroaromatic groups bound directly to the same N atom may be linked by a direct bond or divalent linking group.

13. The organic light-emitting device according to claim 12 wherein the hole-transporting light-emitting layer consists essentially of the hole-blocking light-emitting material and the hole-transporting polymer.

14. The organic light-emitting device according to claim 12 or 13 wherein the hole-blocking light-emitting material is a phosphorescent light-emitting material.

15. The organic light-emitting device according to any of claims 12-14 wherein a LUMO level of the hole-blocking light-emitting material is at least 0.2 eV further from vacuum than a LUMO level of the hole-transporting copolymer

## Patentansprüche

1. Organisches Licht emittierende Vorrichtung (100) umfassend einer Anode (103); einer Kathode (109); einer ersten Licht emittierenden Schicht (107), die ein erstes Licht emittierendes Material zwischen der Anode (103) und der Kathode (109) umfasst; und eine lochtransportierende Schicht (105), die ein lochtransportierendes Copolymer zwischen der Anode (103) und der ersten Licht emittierenden Schicht (107) und angrenzend an die erste Licht emittierende Schicht umfasst, wobei ein HOMO-Niveau des ersten Licht emittierenden Materials näher am Vakuum liegt als ein HOMO-Niveau des lochtransportierenden Copolymers, und wobei 55-95 Mol-% der Wiederholungseinheiten des lochtransportierenden Copolymers lochtransportierende Wiederholungseinheiten von Formel (III) sind: 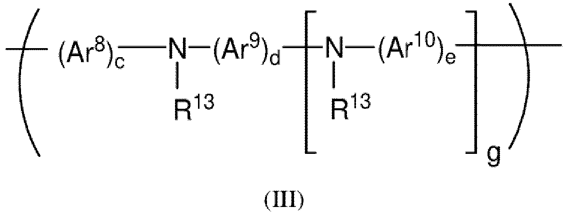 wobei Ar⁸, Ar⁹ und Ar¹⁰ bei jedem Auftreten unabhängig aus substituiertem oder unsubstituiertem Phenylen ausgewählt sind; g 0 oder 1 ist, R¹³ H oder ein Substituent ist; c, d und e jeweils unabhängig 1 sind; und beliebige zwei aromatische oder heteroaromatische Gruppen, die direkt an dasselbe N-Atom gebunden sind, durch eine direkte Bindung oder eine zweiwertige Linkergruppe verknüpft sein können; und wobei das lochtransportierende Copolymer ferner eine Arylen-Co-Wiederholungseinheit umfasst, die unsubstituiert oder mit einem oder mehreren Substituenten substituiert ist.

2. Organisches Licht emittierende Vorrichtung nach Anspruch 1, wobei die lochtransportierende Schicht (105) ferner ein lochblockierendes Licht emittierendes Material umfasst.

3. Organisches Licht emittierende Vorrichtung nach Anspruch 1 oder 2, wobei das erste Licht emittierende Material ein phosphoreszierendes Licht emittierendes Material ist.

4. Organisches Licht emittierende Vorrichtung nach einem der vorhergehenden Ansprüche, wobei die lochtransportierenden Wiederholungseinheiten zwei oder mehr verschiedene lochtransportierende Wiederholungseinheiten beinhalten.

5. Organisches Licht emittierende Vorrichtung nach einem der vorhergehenden Ansprüche, wobei das erste Licht emittierende Material ein grünes oder blaues Licht emittierendes Material ist.

6. Organisches Licht emittierende Vorrichtung nach einem der vorhergehenden Ansprüche, wobei im Wesentlichen das gesamte von der Vorrichtung emittierte Licht Phosphoreszenz ist.

7. Organisches Licht emittierende Vorrichtung nach einem der vorhergehenden Ansprüche, wobei die Vorrichtung eine weißes Licht emittierende Vorrichtung ist.

8. Organisches Licht emittierende Vorrichtung nach einem der vorhergehenden Ansprüche, wobei die Arylen-Co-Wiederholungseinheit ausgewählt ist aus 1,3-Phenylen; 1,4-Phenylen; 3,6-verknüpftem Fluoren; 2,7-verknüpftem Fluoren; Indenofluoren; 1,4-verknüpftem Naphthalin; 2,6-verknüpftem Naphthalin; 9,10-verknüpftem Anthracen; 2,6-verknüpftem Anthracen; und Phenanthren.

9. Organisches Licht emittierende Vorrichtung nach einem der vorhergehenden Ansprüche, wobei zwischen der Anode (103) und der ersten Licht emittierenden Schicht eine leitende Lochinjektionsschicht vorgesehen ist.

10. Verfahren zum Bilden einer organischen Licht emittierenden Vorrichtung nach einem der vorhergehenden Ansprüche, umfassend die Schritte: Bilden der lochtransportierenden Schicht (105) über der Anode (103); Bilden der ersten Licht emittierenden Schicht (107) auf der lochtransportierenden Schicht (105); und Bilden der Kathode (109) über der ersten Licht emittierenden Schicht, wobei die lochtransportierende Schicht (105) und die erste Licht emittierende Schicht (107) jeweils durch Aufbringen einer Formulierung, die das Material oder die Materialien jeder der Schichten und mindestens ein Lösungsmittel umfasst, und durch Verdampfen des mindestens einen Lösungsmittels gebildet werden.

11. Verfahren nach Anspruch 10, bei dem die lochtransportierende Schicht (105) vor der Bildung der ersten Licht emittierenden Schicht vernetzt wird.

12. Organisches Licht emittierende Vorrichtung umfassend einer Anode (103); einer Kathode (109); einer ersten Licht emittierenden Schicht (107) zwischen der Anode (103) und der Kathode (109); einer lochtransportierenden Licht emittierenden Schicht zwischen der Anode (103) und der ersten Licht emittierenden Schicht (107) die ein lochblockierendes Licht emittierendes Material und ein lochtransportierendes Copolymer umfasst,
wobei 55-95 Mol-% der Wiederholungseinheiten des lochtransportierenden Copolymers lochtransportierende Wiederholungseinheiten von Formel (III) sind: 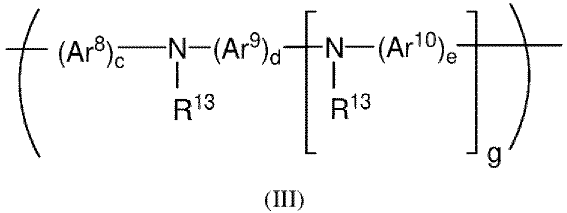 wobei Ar⁸, Ar⁹ und Ar¹⁰ bei jedem Auftreten unabhängig aus substituiertem oder unsubstituiertem Phenylen ausgewählt sind, g 0 oder 1 ist, R¹³ H oder ein Substituent ist; c, d und e jeweils unabhängig 1, 2 oder 3 sind; und beliebige zwei aromatische oder heteroaromatische Gruppen, die direkt an dasselbe N-Atom gebunden sind, durch eine direkte Bindung oder eine zweiwertige Linkergruppe verknüpft sein können.

13. Organisches Licht emittierende Vorrichtung nach Anspruch 12, wobei die lochtransportierende Licht emittierende Schicht im Wesentlichen aus dem lochblockierenden Licht emittierenden Material und dem lochtransportierenden Polymer besteht.

14. Organisches Licht emittierende Vorrichtung nach Anspruch 12 oder 13, wobei das lochblockierende Licht emittierende Material ein phosphoreszierendes Licht emittierendes Material ist.

15. Organisches Licht emittierende Vorrichtung nach einem der Ansprüche 12 bis 14, wobei ein LUMO-Niveau des lochblockierenden Licht emittierenden Materials mindestens 0,2 eV weiter vom Vakuum entfernt ist als ein LUMO-Niveau des lochtransportierenden Copolymers.

## Revendications

1. Dispositif électroluminescent organique (100) comprenant une anode (103) ; une cathode (109) ; une première couche électroluminescente (107) comprenant un premier matériau électroluminescent entre l'anode (103) et la cathode (109) ; et une couche de transport de trous (105) comprenant un copolymère de transport de trous entre l'anode (103) et la première couche électroluminescente (107) et adjacente à la première couche électroluminescente, dans lequel un niveau HOMO du premier matériau électroluminescent est plus proche du vide qu'un niveau HOMO du copolymère de transport de trous et dans lequel 55 à 95 % en moles des unités de répétition du copolymère de transport de trous sont des unités de répétition de transport de trous de formule (III) : 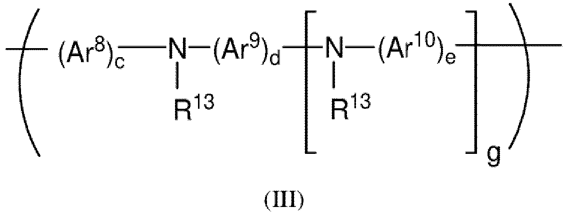 dans lequel Ar⁸, Ar⁹ et Ar¹⁰ dans chaque occurrence sont indépendamment choisis parmi le phénylène substitué ou non substitué ; g vaut 0 ou 1, R¹³ est H ou un substituant ; c, d et e valent chacun indépendamment 1 ; et deux groupes aromatiques ou hétéroaromatiques quelconques reliés directement au même atome N peuvent être liés par une liaison directe ou un groupe de liaison divalent ; et dans lequel le copolymère de transport de trous comprend en outre une unité de co-répétition arylène qui est non substituée ou substituée par un ou plusieurs substituants.

2. Dispositif électroluminescent organique selon la revendication 1, dans lequel la couche de transport de trous (105) comprend en outre un matériau électroluminescent de blocage de trous.

3. Dispositif électroluminescent organique selon la revendication 1 ou 2, dans lequel le premier matériau électroluminescent est un matériau électroluminescent phosphorescent.

4. Dispositif électroluminescent organique selon l'une quelconque des revendications précédentes, dans lequel les unités de répétition de transport de trous comprennent deux unités de répétition de transport de trous différentes ou plus.

5. Dispositif électroluminescent organique selon l'une quelconque des revendications précédentes, dans lequel le premier matériau électroluminescent est un matériau électroluminescent vert ou bleu.

6. Dispositif électroluminescent organique selon l'une quelconque des revendications précédentes, dans lequel pratiquement toute la lumière émise par le dispositif est une phosphorescence.

7. Dispositif électroluminescent organique selon l'une quelconque des revendications précédentes, dans lequel le dispositif est un dispositif électroluminescent blanc.

8. Dispositif électroluminescent organique selon l'une quelconque des revendications précédentes, dans lequel l'unité de co-répétition arylène est choisie parmi le 1,3-phénylène ; 1,4-phénylène ; 3,6-fluorène-lié ; 2,7-fluorène-lié ; indénofluorène; 1,4-naphtalène-lié ; 2,6-naphtalène-lié ; 9,10- anthracène-lié ; 2,6- anthracène-lié ; et phénanthrène.

9. Dispositif électroluminescent organique selon l'une quelconque des revendications précédentes, dans lequel une couche conductrice d'injection de trous est prévue entre l'anode (103) et la première couche électroluminescente.

10. Procédé de formation d'un dispositif électroluminescent organique selon l'une quelconque des revendications précédentes, comprenant les étapes de formation de la couche de transport de trous (105) sur l'anode (103) ; formation de la première couche électroluminescente (107) sur la couche de transport de trous (105) ; et formation de la cathode (109) sur la première couche électroluminescente, dans lequel la couche de transport de trous (105) et la première couche électroluminescente (107) sont chacune formées en déposant une formulation comprenant le ou les matériaux de chaque dite couche et au moins un solvant et évaporation de l'au moins un solvant.

11. Procédé selon la revendication 10, dans lequel la couche de transport de trous (105) est réticulée avant la formation de la première couche électroluminescente.

12. Dispositif électroluminescent organique comprenant une anode (103) ; une cathode (109) ; une première couche électroluminescente (107) entre l'anode (103) et la cathode (109) ; une couche électroluminescente de transport de trous entre l'anode (103) et la première couche électroluminescente (107) comprenant un matériau électroluminescent de blocage de trous et un copolymère de transport de trous,
dans lequel 55 à 95 % en moles des unités de répétition du copolymère de transport de trous sont des unités de répétition de transport des trous de formule (III) : 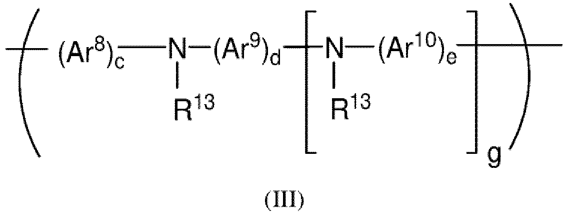 dans lequel Ar⁸, Ar⁹ et Ar¹⁰ dans chaque occurrence sont indépendamment choisis parmi un phénylène substitué ou non substitué, g vaut 0 ou 1, R¹³ est H ou un substituant ; c, d et e valent chacun indépendamment 1, 2 ou 3 ; et deux groupes aromatiques ou hétéroaromatiques quelconques reliés directement au même atome N peuvent être liés par une liaison directe ou un groupe de liaison divalent.

13. Dispositif électroluminescent organique selon la revendication 12, dans lequel la couche électroluminescente de transport de trous est essentiellement constituée du matériau électroluminescent de blocage de trous et du polymère de transport de trous.

14. Dispositif électroluminescent organique selon la revendication 12 ou 13, dans lequel le matériau électroluminescent de blocage de trous est un matériau électroluminescent phosphorescent.

15. Dispositif électroluminescent organique selon l'une quelconque des revendications 12 à 14, dans lequel un niveau LUMO du matériau électroluminescent de blocage de trous est plus éloigné du vide d'au moins 0,2 eV qu'un niveau LUMO du copolymère de transport de trous.
